Europäisches Patentamt

European Patent Office

Office européen des brevets

(19)

(11) Publication number: **0 157 053**
A2

(12)

# EUROPEAN PATENT APPLICATION

(21) Application number: **84308883.2**

(22) Date of filing: **19.12.84**

(51) Int. Cl.⁴: **H 03 L 7/00, H 04 L 7/02**

(30) Priority: **19.03.84 US 591031**

(71) Applicant: **Western Digital Corporation, 2445 McCabe Way, Irvine California 92714 (US)**

(43) Date of publication of application: **09.10.85 Bulletin 85/41**

(72) Inventor: **Hull, Richard William, 24781 Lagrima, Mission Viejo California 92692 (US)**
Inventor: **Tolsch, Donald Edward, 21764 Lake Vista, El Toro, California 92630 (US)**
Inventor: **Wang, James Heung Ping, 1904 W.Victoria Avenue, Anaheim, California 92804 (US)**

(84) Designated Contracting States: **AT DE GB IT**

(74) Representative: **Hallam, Arnold Vincent, E.N. LEWIS & TAYLOR 144 New Walk, Leicester LE1 7JA (GB)**

(54) **High order digital phase lock loop system.**

(57) A digital data separator operates to separate data pulses from clock pulses in MFM encoded signals read from a magnetic disk system. The data separator includes a digital phase lock loop system incorporating a variable length shift register which functions as a variable oscillator and a programmed logic array which controls the operation of the shift register and provides phase detection and filtering functions. The PLA filters high frequency noise components from the incoming data signals and enables the system to accurately track frequency variations in the data stream while providing high tolerance to high frequency noise.

HIGH ORDER DIGITAL

PHASE LOCK LOOP SYSTEM

BACKGROUND OF THE INVENTION

 1.    Field of the Invention

The present invention relates to phase lock loop systems and more particularly to digital phase lock loop systems. Phase lock loops are employed to generate a clock signal which is frequency and/or phase referenced to an external input signal. Phase lock loop systems are used in many fields of communications, and are also employed in computer applications for data synchronization from peripheral sources. The present invention is particularly directed to the use of phase lock loops for data separation in disk drive systems when reading data information which is interspersed with clock information.

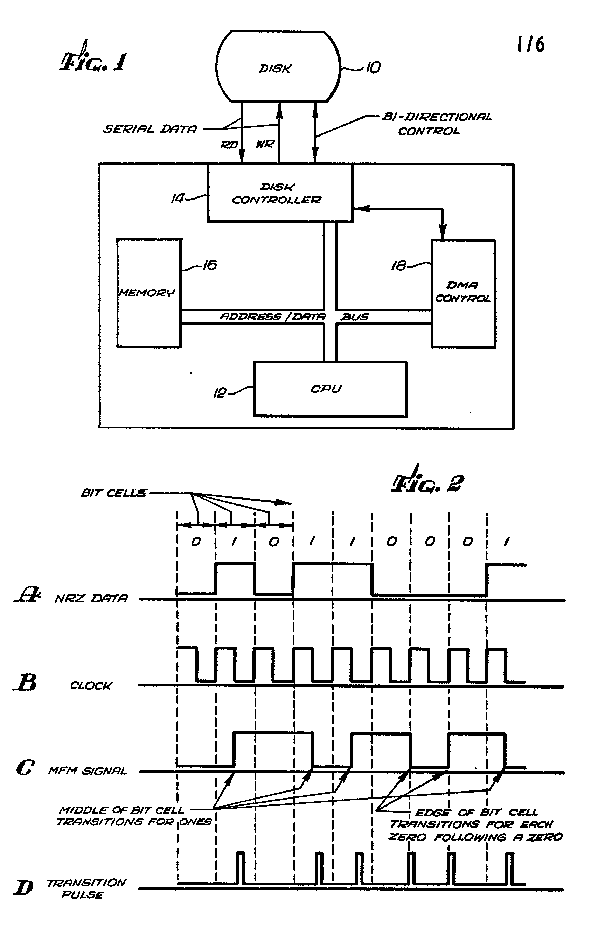

Figure 1 illustrates a typical computing system in which data is transmitted between a memory disk system 10 and a central processing unit (CPU) 12. A disk controller 14 is responsible for executing CPU initiated commands to the disk drive electronics. This includes writing properly formatted serial data to the disk and accurately recovering data from the disk. The computing system also typically includes an internal memory 16 and a direct memory access (DMA) control 18.

Data written onto a disk consists of logic ones and zeros which are written at a particular data, or bit cell, rate. In order to accurately read the data from the disk, the data rate of the signal being read must be known. This is facilitated by encoding data which is written onto the disk so that the signals include clock as well as data information. The embedded clock information is then employed to determine the data rates when signals from the disk are being read.

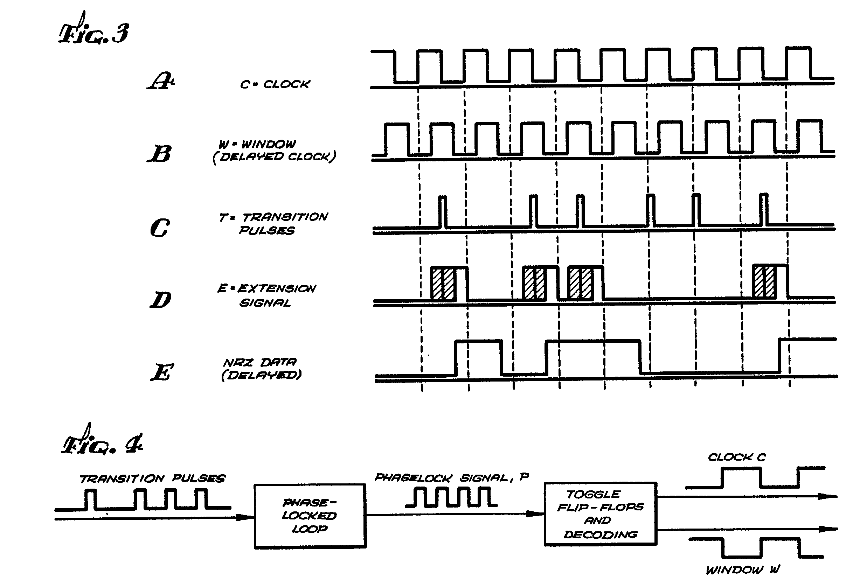

Data is most commonly encoded on a disk and modified frequency modulation (MFM) formed. MFM is a digital signal, derived from the original non-return-to-zero (NRZ) data stream and a synchronous clock signal. The rules of MFM encoding are that each NRZ logic one causes a transition in the MFM signal at the center of the bit cell, and if an NRZ logic zero follows a logic one, the state of the MFM signal does not change. If a logic zero follows another logic zero, there is an MFM transition at the boundary between the two bit cells. An example of MFM coding is shown in Figure 2. The NRZ data shown in Figure 2A is comprised of a series of ones and zeros, each occupying a bit cell. A clock signal indicated in Figure 2B defines the bit cells. The MFM signal shown in Figure 2C may be generated from the NRZ data and clock signals by exclusive-oring the data and clock to form a phase encoded signal, and then dividing the number of transitions by two with a toggle flip-flop. It is only the MFM transitions, not their senses, that are essential to decoding. Typically, disk read electronics are employed so that the signal recovered from a disk is in the form of a narrow pulse for each MFM transition, as shown in Figure 2D.

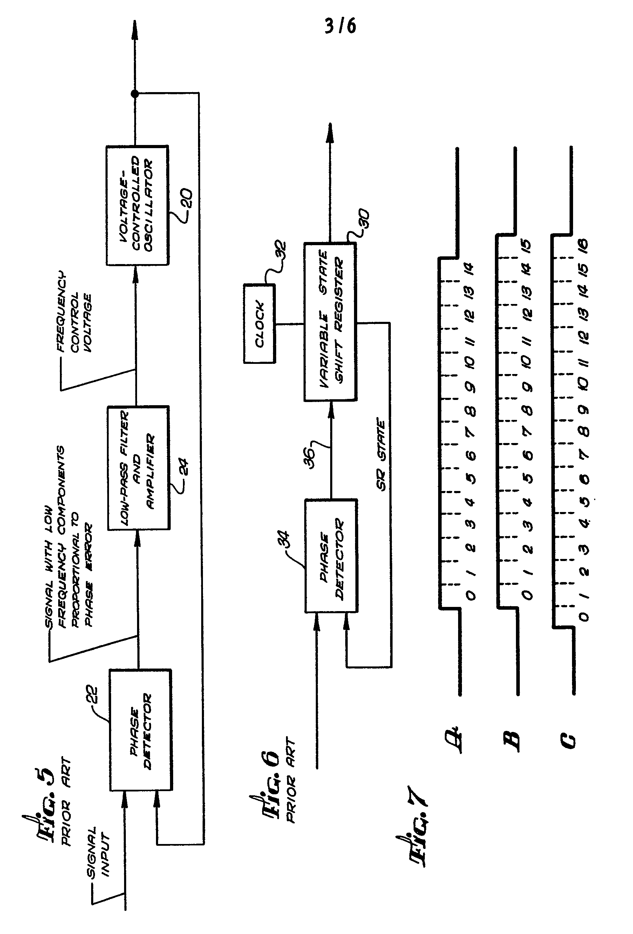

NRZ data may be recovered from MFM transitions as shown in Figure 3. A window signal W, which is a delayed clock C, is generated and used to distinguish center-of-bit-cell (data) from boundary-of-bit-cell (clock) pulses. Each transition pulse T that occurs during the window latches a window extension signal E until the positive clock transition at the end of the bit cell. When E is high at the end of the window (negative transition of W) the NRZ data is a logic one; when E is low at that time, the NRZ data is a logic zero.

Ideally, the clock rate of data read from the disk is a known fixed value. Due to various factors, however, such is not the case, and the clock rate of the data must be determined by looking at the data itself and generating the clock and window signals at the appropriate frequency to track the data. The clock signal is recovered from the MFM data using a phase locked loop driven by the transition pulses. The function of the phase lock loop is to provide clock signals which are equal to the clock rate of the data being read. Although the clock rate has a known ideal value, the actual clock rate of the data will vary from the ideal due to several factors. These factors include variations in the speed that the data track moves past the read head of the disk drive, including both long-term and short-term disk speed variations and non-concentricity and warping of the circular data tracks. The purpose of the phase lock loop is to generate clock signals which follow such data rate variations.

In addition to variations in the actual data rate, the timing of MFM pulses read from a disk deviate from the ideal due to high frequency noise at the read head from external sources and adjacent tracks and noise in the read electronics, as well as other factors. The noise results in random bit jitter (movement of transition pulses from their ideal positions) which is unrelated to variations in the data rate. Since the clock is recovered by reading the MFM pulses, the bit jitter can adversely affect the recovery of the clock signals.

2. Description of the Prior Art

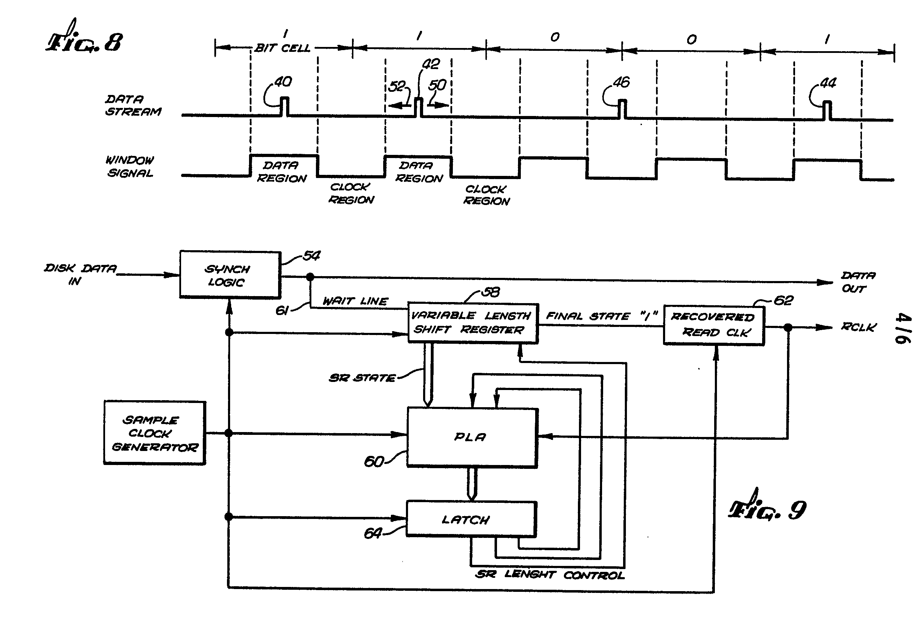

To recover the original NRZ data and clock, a phase locked loop (Figure 4), driven by the transition pulses, reconstructs the clock signal, and the recovered clock and transition pulses are then decoded to give NRZ
data.  Typically, the clock signals are delayed a
quarter of the clock period, and the delayed signal is
used as a window to distinguish transitions occurring
near the center of a bit cell from those occurring near
the edge of each bit cell.  Since only MFM transitions
are avilable, the clock and window signals cannot be
uniquely identified with respect to the data stream.
In practice MFM decoding is done using both signals as
windows and the detection of a unique code is employed
to determine which is the correct decoded MFM signal.

    Ideally, each transition will occur precisely
in the middle of the window signal.  This will not always
be the case, however, because of low frequency data rate
variations which are not precisely tracked by the phase
lock loop and because of high frequency bit jitter.  If
the transition moves outside of the limits of the window,
a read error will result. In order to accurately track
the data rate of the MFM data transitions, the shift in
the position of the transitions as a result of bit jitter
should be ignored, whereas the shift in positions of the
transitions as a result of change in the frequency of the
data should be used to correct the frequency of the
recovered clock and resultant window.

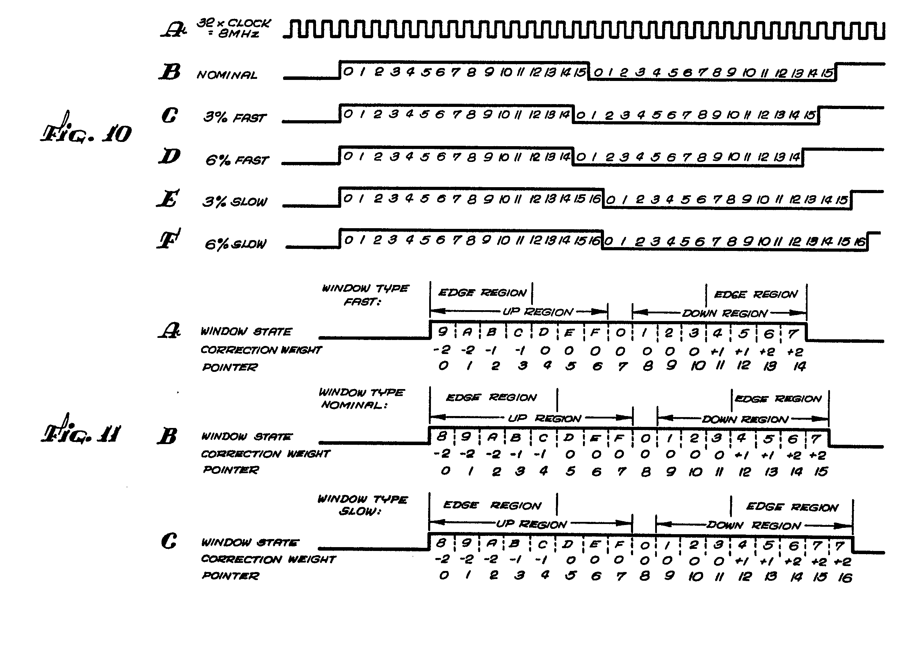

    The most common prior art systems employ
an analog phase lock loop which incorporates low pass
filtering in order to eliminate the effects of bit jitter
on the generation of the recovered clock.  Such a system
is illustrated in Figure 5.  A voltage controlled oscil-
lator (VCO) 20 is employed to generate the clock signals.
The output of the VCO is applied to a phase detector 22,
where its phase is compared to the phase of the input
signal (transition pulses).  The output of the phase
detector 22 is a signal with low frequency components
proportional to the phase error and high frequency
components resulting from bit jitter.  This signal
is applied to a low pass filter and amplifier 24 which attenuates the high frequency components resulting from bit jitter. The output of the filter and amplifier is a control voltage which is applied to the VCO 20 to control its output frequency.

Although the analog phase lock loop circuit of Figure 5 generally has good performance, it has several disadvantages. Such analog circuits are difficult to design and build and require a large amount of circuit board space. Additionally, they require adjustments to properly align the circuits in the system, i.e., to adjust the VCO frequency and gains and currents of various components. These adjustments are expensive in terms of production costs since they result in lower throughput and require technician overhead during controller board manufacturing.

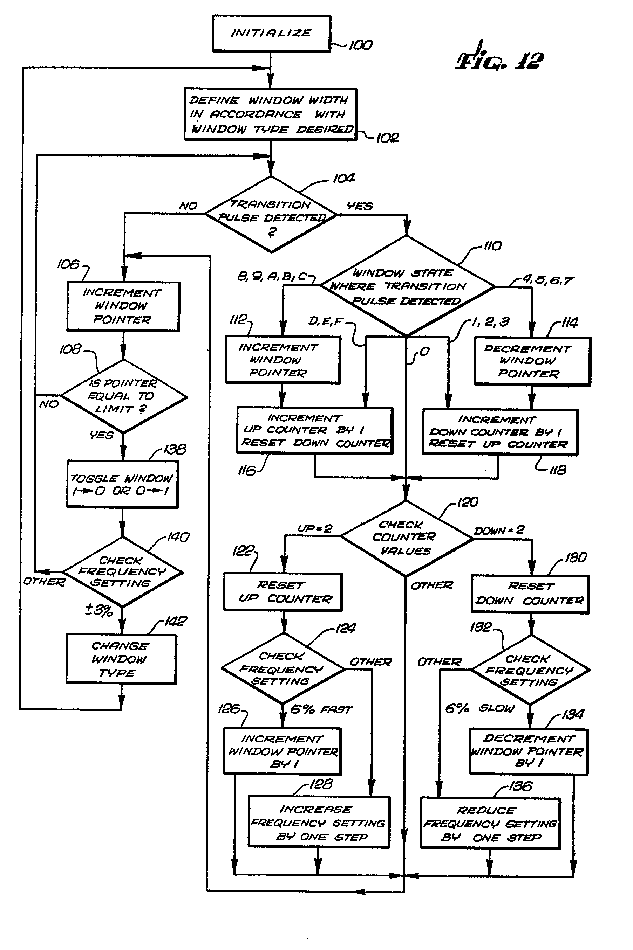

Digital phase lock loop systems have been designed in the past. A typical system is illustrated in Figure 6. In such systems, a variable multiple state component such as a counter or shift register 30 performs a function analogous to the VCO of the analog phase lock loop. The shift register is driven by a sample clock 32. The carry output of the shift register provides an output signal of variable frequency which is used to toggle the recovered clock and window signal. The output frequency of the shift register is varied by adding or subtracting states, as illustrated in Figure 7. For example, the shift register 30 may have sixteen nominal states, as illustrated in Figure 7B. In order to reduce the frequency of the window signal, one state is added, as illustrated in Figure 7C, and in order to increase the frequency of the window signal, one state is subtracted, as illustrated in Figure 7A.

A phase detector 34 is implemented with a microprocessor or logic array and determines when the transition pulses arrive with respect to the states of the shift register. The logic array incorporates an algorithm to determine frequency corrections as a function of the determination of the state of occurrence of the transition pulses. If a transition pulse does not arrive in the correct state, the phase detector provides an error signal on line 36 to alter the number of states, and thus the output frequency, of the shift register 30. Some prior art systems make only instantaneous corrections in the number of states per window as a function of the arrival of a transition pulse in that particular window. Other systems make both instantaneous corrections to a window based upon the occurrence of a transition pulse in that particular window as well as making long-term corrections based upon the occurrence of transition pulses with respect to previous windows.

The primary disadvantage of prior digital phase lock loops is that they are first order, i.e., they do not incorporate the concept of a filter. As a result, bit jitter adversely affects the operation of the phase lock loop. This is to be contrasted with higher order analog phase lock loop systems in which the bit jitter is filtered out and does not affect the frequency tracking operation of the system. Since they are only first order, prior art digital phase lock loops used as disk data separators have very low performance, i.e., high data recovery error rates.

Several attempts have been made to produce higher order digital phase lock loop systems. Although some of these systems provide some degree of improvement in performance, none of them has achieved second order or higher operation. In addition, digital phase lock loops have yet to achieve adequate performance when employed in disk data separators.

## SUMMARY OF THE INVENTION

The present invention is directed to a digital phase lock loop system which achieves true second order and higher performance. When implemented as part of a disk data separator, the system operates to effectively ignore bit jitter and track true frequency variations in the data stream. In the present embodiment of the invention, phase detection and error amplification is provided by a programmed logic array (PLA) which drives a variable state shift register to change the frequency of the shift register if approriate. Filter operation is provided by latching additional PLA output terms and feeding them back to the PLA at later clock times. By providing a system in which shifts in the occurrence of transition pulses due to bit jitter are ignored in generating the window signal, very accurate data separation is achieved, i.e., read errors are minimized. The shift register is analogous to a digital VCO, and the number of states of the shift register is controlled as a function of the detection of transition pulses both in the window being generated as well as in previous windows.

BRIEF DESCRIPTION OF THE DRAWINGS

The invention will be described with reference to the accompanying drawings, wherein:

FIGURE 1 is a block diagram of a typical disk drive/CPU system;

FIGURES 2A-D are waveforms illustrating MFM encoded signals;

FIGURES 3A-E are waveforms illustrating MFM decoding;

FIGURE 4 is a block diagram of a phase-locked loop (PLL) system to recover the clock and generate the window for data separation;

FIGURE 5 is a block diagram of a PLL circuit arrangement;

FIGURE 6 is a block diagram of a digital PLL arrangement;

FIGURES 7A-C are waveforms of 15-, 16- and 17-state windows of the shift register of FIGURE 6.

FIGURE 8 is an expanded waveform diagram illustrating the relation between a data stream and window signals;

FIGURE 9 is a block diagram of the present invention;

FIGURES 10A-F are waveforms of the sample clock and various frequency bit cells employed in the present invention;

FIGURE 11 is a diagram of windows of the present invention showing various designations of different states of the windows; and

FIGURE 12 is a simplified flowchart of the algorithm employed in the present invention.

## DESCRIPTION OF THE PREFERRED EMBODIMENT

The following description is of the best presently contemplated mode of carrying out the invention. This description is for the purpose of illustrating the general principles of the invention and should not be taken in a limiting sense. The scope of the invention is best determined by the appended claims.

Referring to Figure 8, a sample data stream of transition pulses representing a data pattern 11001 is illustrated. Transition pulses 40, 42 and 44 occur in the middle of their respective bit cells, while transition pulse 46 occurs at the edge of its bit cell. The function of the phase lock loop of the digital data separator is to generate a window signal 48 which enables center of bit cell transition pulses to be discriminated from edge of bit cell transition pulses. In an ideal system, each center of bit cell transition pulse will occur in the center of a window. However, the pulses may fall to either side of center as illustrated by arrows 50 and 52 as a result of low frequency data rate variations or high frequency bit jitter. The purpose of the present invention is to provide a digital data separator which will alter the frequency of the window signal in order to track low frequency variations of the data stream but will ignore the effects of high frequency bit jitter on the data stream. By accurately tracking low frequency variations, tolerance to bit jitter will be increased, i.e., the transition pulses will fall within the windows despite a relatively large amount of bit jitter.

Figure 9 is a block diagram of the digital data separator of the present invention. The input to the separator directly from the disk drive contains both MFM clock and data information. The clock is recovered from the input signal to provide the window for separation to determine whether a transition pulse falls in a data region or in a clock region. The separator then denotes the position of the transition pulse with respect to the window and adjusts the window according to a specific algorithm. The goal of the algorithm is to keep the pulses close to the center of the window as much as possible to allow maximum tolerance to bit jitter. If the transition pulses are always placed in the center of the window, then the recovered clock will run at a nominal rate. However, if the pulses come too soon, then the recovered clock will be adjusted to run faster. Conversely, if the pulses come too slow, the recovered clock will be adjusted to run slower.

The transition pulses are applied to synch logic 54 comprised of an asynchronous to synchronous detector which synchronizes the transition pulses with pulses from a sample clock 56. Each transition pulse from the logic 54 has a pulse width of one sample clock pulse. In the present embodiment of the invention, the digital data separator is used in conjunction with a floppy disk system, and the nominal bit cell rate is 250 kHz. The sample clock 56 is a 32x clock, i.e., 8 mHz. The synchronized output of the synch logic 54 is applied along a "wait line" 61 to the shift input of an 18 bit (state) variable length ring shift register 58, which performs a function analogous to a voltage controlled oscillator in an analog PLL. The shift register is clocked by the sample clock 56 and is operated so that a single "one" is circulated in the ring. A programmed logic array (PLA) 60 monitors the shift register state and determines when the circulating one is in some final state. The initial shift register state is then loaded with a "one" while all other states shift to a "zero." Concurrently, the detected "one" in the final state causes recovered read clock circuitry 62 to cause the recovered clock signal RCLK to change state. The RCLK signal is then used to separate data from clock signals from the data stream.

The PLA 60 and an associated latch 64 function to control the length of the shift register 58 and thereby control the frequency of the recovered clock signal RCLK. Both the phase detector and low pass filter functions of an analog PLL are implemented in a digital fashion in the PLA 60 and latch 64. When a synchronized transition pulse arrives at the shift register 58 on the wait line, the PLA 60 recognizes it and computes its phase relationship by determining in which shift register state the pulse arrived. Based upon this determination, appropriate adjustments to the frequency rate at which the ring shift register toggles the resultant clock are calculated. The calculations take into account previous history of pulses and are analogous to the function of the low pass filter in an analog PLL.

The frequency of the RCLK signal is controlled by altering the length of the shift register 58. The sampling clock used to clock the shift register has a frequency thirty-two times that of the nominal bit cell frequency, and the nominal RCLK signal is thus comprised of thirty-two shift register states of sixteen states high and sixteen states low. This results in an RLCK frequency of 250 kHz, i.e., the same as the nominal bit cell rate. The sample clock waveform is indicated in Figure 10A and the nominal frequency cell is indicated in Figure 10B.

The present invention is designed to track frequency variations of up to plus or minus 6% from the nominal bit cell rate. This is accomplished by adding or subtracting states from one or both of the high and low portions of a frequency cell both on an instantaneous and long-term basis. Each individual high and low portion of a cell will hereinafter be referred to as a "window." In order to increase or decrease the frequency of the RCLK signal, states are added to or subtracted from one or both of the windows in a frequency cell. Long-term corrections are made by redefining the window length prior to the generation of the windows and employing the preset window length as the running frequency of the system. Instantaneous corrections to each window are then made based upon the detection of a transition pulse in that particular window.

With respect to the preset frequency, a "fast" window is created by subtracting a state from the nominal amount so that the resultant window has fifteen states. A "slow" window is created by adding a state so as to result in seventeen states in a window. Changes in the preset operating frequency of RCLK are accomplished in 3% increments. In order to increase the frequency of RCLK by 3%, the shift register is controlled so that one window in the frequency cell is a nominal sixteen state window, while the other window is a fast fifteen state window, as illustrated in Figure 10C. When a 6% increase in frequency is desired, a state is removed from both windows, as illustrated in Figure 10D. In a similar fashion, a 3% reduction in frequency is achieved by adding a state to one window and a 6% reduction in frequency is achieved by adding a state to each window, as illustrated in Figures 10E and 10F, respectively.

It should be noted that the 32x sampling rate is arbitrary and that frequency changes finer than the 3% and 6% employed in the present invention could be achieved by employing a faster sample clock. The 8 mHz clock of the present invention is close to the maximum feasible with present technology.

The operation of the PLA to achieve phase detection and filtering will now be described. The control provided by the algorithm implemented by the PLA will be described with reference to Figure 11. Each window type, i.e., fast, nominal and slow, is comprised of a plurality of shift register states as described above. The current state of each window is designated by means of a "pointer" which ranges from 0-14 for a fast window, 0-15 for a nominal window and 0-16 for a slow window. The pointer indicates the current state of the shift register 58 (Figure 9), and when the final state is detected, the window signal is caused to toggle. In addition to the pointer designation, each state has a "window state" designation of A-F or 0-9. These designations are employed by the algorithm to make instantaneous frequency and phase corrections in the windows. As can be seen in Figure 11, the window state designations do not necessarily correspond to the pointer designations for each different window type, e.g., for a fast window the window state designation zero corresponds to pointer 7 whereas for nominal and slow window types the window state zero corresponds to pointer 8.

The frequency cell type and window type are determined prior to the generation of the windows. That is, the system will be preset to run at a particular RCLK frequency and each window will be generated based upon the preset value. Initially, the shift register is set to run at the nominal rate (i.e., sixteen states per window). Ideally, each data pulse should arrive at state 0 (window state designation). If a data pulse does arrive at state 0, no correction of any kind is implemented. If a data pulse arrives in a state other than state 0, there is a frequency error and/or bit jitter. As indicated in Figure 11, the window states are divided into an "up" or increase region to the left of designated window state zero and a "down" or decrease region to the right of state zero. If two consecutive pulses occur in the up region, it is taken as an indication that the frequency of the clock is too slow. Similarly, if two consecutive pulses arrive in the down region, it is taken as an indication that the frequency of the clock is too fast. An isolated pulse in either region is assumed to be caused by bit jitter. By waiting to adjust the preset frequency until two consecutive pulses are received in either the up region or down region, a rough filtering of the bit jitter is accomplished. The use of the up and down regions serves to track frequency variations of up to plus or minus 6% in 3% increments.

Since corrections in the recovered clock frequency can only be made in 3% increments, it is necessary to periodically add or subtract states from windows in order to track frequency variations which do not precisely correspond to the 3% increments. In addition, further filtering of the bit jitter is required beyond that provided by the frequency control in order to provide good performance. This is accomplished by making instantaneous corrections in each window. In addition to being divided into the up and down regions, the windows are also divided into edge regions in which instantaneous corrections in the length of each window are made to change the frequency for that particular window. If a pulse falls in an edge region, there is a relatively large phase error and/or a large amount of bit jitter. Instantaneous corrections in the length of the window are accomplished by adding or subtracting states in accordance with correction weights indicated in Figure 11. These instantaneous corrections serve to reposition the data pulse closer to the center of the window. By altering the length of the current window, the phase of the window signals is altered to be closer to that of the data signals. However, the frequency setting of the window signals still is not changed until two consecutive pulses are received in an up or down region.

The instantaneous corrections which take place when a data pulse occurs in an edge region provides a smoothing function to enable tracking of frequency variations of other than 3% or 6% from nominal and also perform a filtering action to prevent changes in the preset frequency setting which would otherwise result from bit jitter. Since the instantaneous corrections move the transition pulse closer to the center of the particular window, it is less likely that the subsequent transition pulse will fall within the same up or down region as the previous pulse, and a change in frequency setting is therefore less likely to occur. The various correction weights assigned to the different states of the edge regions serve to provide the filtering action analogous to an analog filter. Since pulses occurring relatively far away from the window state zero are more likely to be due to bit jitter or phase error rather than frequency error, a larger instantaneous correction is employed so that subsequent frequency corrections are less likely. The system thus has lower "gain" corresponding to window states relatively far away from state zero. Since pulses occurring in these window states are often a result of high frequency jitter, it can be seen that the algorithm functions as a low pass filter, with the gain of the filter being reduced as the frequency increases.

Thus, in the present invention, one of five RCLK frequencies is preset by the algorithm as the running frequency of the system, and window signals will be generated in accordance with the present frequency. The algorithm divides each window into up and down regions and monitors successive transition pulses to make corrections in the preset frequency in 3% increments. In addition, instantaneous corrections are made in individual windows in which a transition pulse occurs in an edge region to perform smoothing (to compensate for the fact that frequency changes can only be made in 3% increments) and filtering. In the preferred embodiment of the invention, the data separator provides a bit jitter tolerance of 375 nanoseconds for any frequency within plus or minus 6% of the nominal frequency rate. This is to be compared with prior art digital data separators which achieve a bit jitter tolerance of 125 nanoseconds or worse for a frequency variation of plus or minus 6%.

A simplified version of the control program of the PLA 60 is shown in Figure 12. The PLA implemented in the present embodiment of the invention is an eleven input, twelve output device in which five inputs receive a binary encoding of the state of the shift register 58, one input receives the current window value (a one or a zero), three inputs are for encoded bits representing the current frequency cell type (nominal, 3% fast or slow, 6% fast or slow), one input represents the detection of two consecutive pulses in an up region, and one input represents the receipt of two consecutive pulses in a down region. Of the twelve outputs of the PLA, seven each enables one of seven instantaneous correction factors in the length of a window, three represent a binary encoding of the next frequency cell type, one signifies that a pulse was a first one received in an up region, and one signifies that a pulse received is the first in a down region. The PLA outputs are provided to the latch 64, which in turn provides shift register length corrections to the shift register and feedback signals to the PLA regarding the presence of previous pulses in an up or down region.

The first step of the algorithm is an initialization step, step 100. In this step, the frequency cell type is set at nominal by setting a nominal frequency flag to one and 3% slow, 3% fast, 6% slow and 6% fast frequency flags to zero. In addition, first and second internal counters in the PLA which are employed to keep track of data pulses occurring in the up and down regions are reset. In the second step, step 102, the type of window is determined (nominal, slow or fast) in accordance with the frequency cell type, and the maximum value, or pointer limit, of the shift register 58 is set to correspond to the window type. Thus, the pointer limit will be set to define a window of fifteen, sixteen, or seventeen states. Initially, since the frequency cell type is set to nominal, the window width will be set to nominal, i.e., sixteen states.

The PLA 60 controls generation of window signals in accordance with the state of the shift register 58. Initially, the window pointer will be at zero and the PLA will determine if a transition pulse has been detected in pointer zero, step 104. If no pulse is detected, the window pointer will be incremented, step 106, and compared with the pointer limit, step 108. If the window pointer has not reached the pointer limit (i.e., the last state of the currently defined window), it returns to step 104. The incrementing of the window pointer is done under control of the sample clock which controls the shifting of the shift register 58, and the incrementing of the window pointer thus corresponds to a change of state of the register.

The shifting of the register continues under control of the sample clock until a transition pulse is detected. When a transition pulse occurs on the wait line 61, the shifting of the register 58 is halted. This action is detected by the PLA as signifying the occurrence of a transition pulse, step 104. Once the transition pulse is detected, the window state at which the transition pulse occurred is determined, step 110. The instantaneous corrections of the length of the window are implemented by incrementing or decrementing the window pointer (representative of the current state of the window), steps 112 and 114, so as to reposition the pulse in the predefined window. The shifting of the window pointer in effect results in the addition or subtraction of states from that particular window. As discussed with respect to Figure 11, if the transition pulse occurred in window state 8, 9 or A the window pointer is incremented by two and if the transition pulse were detected in window state B or C the window pointer is incremented by one. Similarly, the window pointer is decremented by two if the transition pulse occurs in window states 6 or 7 and decremented by one if the transition pulse occurs in window states 4 or 5.

In order to keep track of pulses occurring in up and down regions, internal up and down counters are provided. If a pulse occurs in an up region, the up counter is incremented and the down counter is reset, step 116. Similarly, if a pulse occurs in a down region, the down counter is incremented by one and the up counter is reset, step 118. The counter values are then checked to determine if two consecutive pulses have occurred in an up or down region, step 120. If two consecutive pulses have occurred in the up counter, the up counter is reset, step 122, and the frequency flag setting is determined. If the frequency flag setting is already at 6% fast, no additional changes in the preset frequency of the window signals can be made, and the window pointer is therefore incremented by one, step 126, on the assumption that the error is due to bit jitter. For any other frequency setting, the occurrence of two consecutive up pulses indicates that the frequency of the window is too low, and the frequency setting is therefore increased by one step, step 128. For example, if the frequency flag setting were at 3% slow, it would change it would be changed to nominal, whereas if it were at nominal, it would be changed to 3% fast. In a similar fashion, if two consecutive down counts are received, the window pointer is decremented by one or the frequency flag setting reduced by one step, as indicated in steps 130-136.

The algorithm steps 110-136 thus implement the instantaneous and frequency corrections discussed with respect to Figure 11. After the necessary corrections have been made, the window pointer is again incremented, step 106, and steps 108 and 104 are repeated until the final window state is reached at step 108. At this point, the window signal is toggled, step 138. The frequency flags are then checked to determine the frequency setting, step 140. If the frequency setting
is 3% fast or 3% slow, the window type must be changed,
step 142, since frequency cells of this type alternate
between fast and nominal or slow and nominal window
lengths as indicated in Figures 10C and 10E. If the
window type is changed, the system returns to step 102
and the new window width (pointer limit) is defined.
For all other frequency settings, the system returns
to step 104. The sequence then repeats itself until
the occurrence of the next transition pulse.

In the specific embodiment of the present invention, the shift register 60 is held in the wait state
for three sample clock pulses. During this time period,
the PLA is enabled and decodes all of the algorithm flags
as well as certain hardware specific flags. It is this
decoding which provides the phase detection/low pass
filter functions. At the end of the third sample clock
pulse, all of the PLA outputs are latched and the final
shift register state is determined. The holding of the
shift register is accomodated by making an instantaneous
correction in the window state to reposition the "1" in
the shift register in the correct state. It should be
noted, however, that the fundamental functions of the
algorithm could be implemented in many different
fashions.

Thus, the present invention provides a digital
phase lock loop system in which a variable length shift
register or other counting element is controlled by
means of an algorithm to provide a variable frequency
output. The frequency is varied by adding or removing
states from the shift register, and the algorithm
implements both phase detection and low pass filtering
functions. The low pass filtering provides high performance when the system is used in a digital data
separator for magnetic disk systems.

WHAT IS CLAIMED IS:

1.    A digital phase lock loop system for providing a digital output signal synchronized with a stream of data pulses having a nominal data frequency, said stream of data pulses being subject to low frequency variations in the data frequency and high frequency variations unrelated to changes in the data frequency, said system comprising:

variable oscillator means for generating a digital output signal comprised of a plurality of pulse windows in which each window is defined by a plurality of successive states of equal duration; and

processing means for controlling the number of states in each window as a function of the phase difference between the output signal and the stream of data pulses, said processing means including means for filtering phase differences resulting from said high frequency variations in the stream of data pulses thereby to accurately track said low frequency variations.

2.    The system of claim 1 wherein the processing means comprises means for determining the phase of each data pulse with respect to a window in which it occurs, means for controlling the number of states in each window as a function of the determined phase for the data pulse occurring in that window and means for controlling the number of states in each window as a function of the determined phase for the data pulse occurring in that window and the determined phase for a data pulse occurring in at least one previous window.

3. The system of claim 2 wherein:

the phase of each data pulse is determined by determining the state of a window in which the data pulse occurs;

each state of a window has an instantaneous correction weight associated with it, wherein the total number of states in the window is altered in correspondence with the correction weight of the state in which the data pulse occurs; and

various states of each window are separated into increase regions and decrease regions, wherein the total number of states in the window is increased if data pulses occur in the increase region in successive windows and the number of states in the window is decreased if data pulses occur in the decrease region in successive windows.

4. The system of claim 3 wherein the number of states in each window, and therefore the frequency of the window pulses, is set prior to the generation of each window and wherein:

alterations in accordance with the instantaneous correction weights are accomplished on a window-by-window basis; and

alterations in accordance with the occurrence of successive pulses in the increase or decrease regions are accomplished to alter the set number of states, and therefore frequency, for subsequent window pulses.

5. The system of claim 1, 2, 3 or 4 wherein the variable oscillator means comprises a variable length shift register.

6. The system of claim 1, 2, 3, 4 or 5 wherein the processing means comprises a programmed logic array.

7. A digital phase lock loop system for providing a clock signal of successive windows of high and low values which is phase and frequency referred to an external data pulse input signal having a nominal data frequency, wherein said input signal is subject to low frequency variations about the nominal frequency and random high frequency variations, the system comprising:

a sample clock;

a variable length multiple state ring shift register, driven by the sample clock, wherein each window of the system clock signal is defined by the number of states in the shift register; and

processing means for controlling the number of states in the shift register to thereby control the frequency of the system clock signal, said processing means including:

means for determining for each window the shift register state in which an external data pulse arrives to thereby determine the phase of the data pulses with respect to the windows;

means for setting the number of states, and therefore the clock frequency, in each window prior to the generation of the window;

means for correcting the state setting for subsequent windows as a function of the determination of the state of arrival of a data pulse, including means for filtering the high frequency variations of the data pulses to minimize their effect on correction of state settings for subsequent windows.

8.  The system of claim 7 wherein:
plural states in each window to one side of a
reference state are in an increase region and plural
states to the other side of the reference state are
in a decrease region, wherein the means for correcting
increases the state setting when data pulses arrive
in increase regions in consecutive windows and decreases
the state setting when data pulses arrive in decrease
regions in consecutive windows.

9.  The system of claim 8 wherein each state of
each window has an instantaneous correction weight
associated with it, wherein the means for filtering
includes means for altering the number of states in a
window in accordance with the correction weight of the
state in which a data pulse occurred in that window,
wherein said altering has no effect on the state setting
for subsequent windows.

10.  The system of claim 9 wherein said correction
weights are greatest in magnitude at the edges of each
window and least in magnitude near the center of each
window.

11.  The system of claim 7,8,9 or 10 wherein the
processing means comprises a programmed logic array.

12.    In a data separator for separating clock
from data transition pulses in MFM encloded signals
having a nominal data rate and being subject to high
frequency variations unrelated to the nominal data rate,
a digital phase lock loop system for generating a
recovered clock signal in response to the reading of the
transition pulses, comprising:

a sample clock having a frequency which is a
multiple of a nominal frequency of the MFM signal;

a variable multiple state counting means driven
by the sample clock and providing an output signal to
toggle the recovered clock signal after a window comprised of some number of sample clock pulses as defined
by the number of states of the counting means;

processing means for controlling the number of
states in each window as a function of a determination
of the state of occurrence of transistion pulses in the
windows, said processing means including means for
filtering the effects of variations in the locations of
transition pulses in the windows caused by high frequency
variations, said processing thereby causing the recovered
clock signal to accurately track low frequency variations
in the MFM encoded signals about the nominal data rate.

13.    The system of claim 12 wherein each window has a reference state and a plurality of states in an increase region to one side of the reference state and a plurality of states in a decrease region to the other side of the reference state, and wherein each state in a window has an instantaneous correction weight associated with it, wherein the processing means comprises means for:

setting the number of states per window prior to the generation of each window in accordance with a desired recovered clock frequency;

determining if transition pulses occur in either successive increase regions or successive decrease regions and, if so, altering the set number of states per window in accordance with a new desired frequency;

altering the number of states in each window in accordance with the correction weight associated with the state of occurrence of a transition pulse in that window.

14.    The system of claim 13 wherin the correction weight is zero for the reference state and increases to a maximum at each edge of every window.

**FIG. 1**

DISK 10

SERIAL DATA — BI-DIRECTIONAL CONTROL

RD   WR

14 — DISK CONTROLLER

16 — MEMORY

18 — DMA CONTROL

ADDRESS / DATA   BUS

12 — CPU

**FIG. 2**

BIT CELLS

0 | 1 | 0 | 1 | 1 | 0 | 0 | 0 | 1

**A** NRZ DATA

**B** CLOCK

**C** MFM SIGNAL

MIDDLE OF BIT CELL TRANSITIONS FOR ONES

EDGE OF BIT CELL TRANSITIONS FOR EACH ZERO FOLLOWING A ZERO

**D** TRANSITION PULSE

**Fig.3**

A — C = CLOCK

B — W = WINDOW (DELAYED CLOCK)

C — T = TRANSITION PULSES

D — E = EXTENSION SIGNAL

E — NRZ DATA (DELAYED)

2/6

**Fig. 4**

TRANSITION PULSES → PHASE-LOCKED LOOP → PHASELOCK SIGNAL, P → TOGGLE FLIP-FLOPS AND DECODING → CLOCK C

WINDOW W

0157053

## Fig. 5
PRIOR ART

SIGNAL INPUT →

PHASE DETECTOR ╱22

SIGNAL WITH LOW FREQUENCY COMPONENTS PROPORTIONAL TO PHASE ERROR

LOW-PASS FILTER AND AMPLIFIER ╱24

FREQUENCY CONTROL VOLTAGE

VOLTAGE-CONTROLLED OSCILLATOR ╱20

## Fig. 6
PRIOR ART

→ PHASE DETECTOR ╱34

36╱ →

CLOCK ╱32

VARIABLE STATE SHIFT REGISTER ╱30 →

SR STATE

## Fig. 7

A     0 1 2 3 4 5 6 7 8 9 10 11 12 13 14

B     0 1 2 3 4 5 6 7 8 9 10 11 12 13 14 15

C     0 1 2 3 4 5 6 7 8 9 10 11 12 13 14 15 16

Fig. 8

Fig. 9

FIG. 10

**A** 32 x CLOCK = 8MHz

**B** NOMINAL — 0 1 2 3 4 5 6 7 8 9 10 11 12 13 14 15 | 0 1 2 3 4 5 6 7 8 9 10 11 12 13 14 15

**C** 3% FAST — 0 1 2 3 4 5 6 7 8 9 10 11 12 13 14 | 0 1 2 3 4 5 6 7 8 9 10 11 12 13 14 15

**D** 6% FAST — 0 1 2 3 4 5 6 7 8 9 10 11 12 13 14 | 0 1 2 3 4 5 6 7 8 9 10 11 12 13 14

**E** 3% SLOW — 0 1 2 3 4 5 6 7 8 9 10 11 12 13 14 15 16 | 0 1 2 3 4 5 6 7 8 9 10 11 12 13 14 15

**F** 6% SLOW — 0 1 2 3 4 5 6 7 8 9 10 11 12 13 14 15 16 | 0 1 2 3 4 5 6 7 8 9 10 11 12 13 14 15 16

FIG. 11

WINDOW TYPE FAST:

EDGE REGION | ← UP REGION → | ← DOWN REGION → | EDGE REGION

**A**

| WINDOW STATE | 9 | A | B | C | D | E | F | 0 | 1 | 2 | 3 | 4 | 5 | 6 | 7 |
|---|---|---|---|---|---|---|---|---|---|---|---|---|---|---|---|
| CORRECTION WEIGHT | -2 | -2 | -1 | -1 | 0 | 0 | 0 | 0 | 0 | 0 | 0 | +1 | +1 | +2 | +2 |
| POINTER | 0 | 1 | 2 | 3 | 4 | 5 | 6 | 7 | 8 | 9 | 10 | 11 | 12 | 13 | 14 |

WINDOW TYPE NOMINAL:

EDGE REGION | ← UP REGION → | ← DOWN REGION → | EDGE REGION

**B**

| WINDOW STATE | 8 | 9 | A | B | C | D | E | F | 0 | 1 | 2 | 3 | 4 | 5 | 6 | 7 |
|---|---|---|---|---|---|---|---|---|---|---|---|---|---|---|---|---|
| CORRECTION WEIGHT | -2 | -2 | -2 | -1 | -1 | 0 | 0 | 0 | 0 | 0 | 0 | 0 | +1 | +1 | +2 | +2 |
| POINTER | 0 | 1 | 2 | 3 | 4 | 5 | 6 | 7 | 8 | 9 | 10 | 11 | 12 | 13 | 14 | 15 |

WINDOW TYPE SLOW:

EDGE REGION | ← UP REGION → | ← DOWN REGION → | EDGE REGION

**C**

| WINDOW STATE | 8 | 9 | A | B | C | D | E | F | 0 | 1 | 2 | 3 | 4 | 5 | 6 | 7 | 7 |
|---|---|---|---|---|---|---|---|---|---|---|---|---|---|---|---|---|---|
| CORRECTION WEIGHT | -2 | -2 | -2 | -1 | -1 | 0 | 0 | 0 | 0 | 0 | 0 | 0 | +1 | +1 | +2 | +2 | +2 |
| POINTER | 0 | 1 | 2 | 3 | 4 | 5 | 6 | 7 | 8 | 9 | 10 | 11 | 12 | 13 | 14 | 15 | 16 |

0157053

**Fig. 12**